# FASCICULE DE BREVET EUROPEEN

(11) **EP 2 132 776 B1**
(45) Date de publication et mention de la délivrance du brevet: **18.06.2014**
(21) Numéro de dépôt: 08717503.0
(22) Date de dépôt: 07.03.2008
(51) Int. Cl.: H01L 27/146, H01L 23/544

(54) **BOÎTIER DE CIRCUIT INTEGRE, NOTAMMENT POUR CAPTEUR D'IMAGE ET PROCEDE DE POSITIONNEMENT.**
GEHÄUSE EINER INTEGRIERTEN SCHALTUNG INSBESONDERE FÜR EINEN BILDSENSOR UND POSITIONIERUNGSVERFAHREN
INTEGRATED CIRCUIT HOUSING PARTICULARLY FOR AN IMAGE SENSOR AND POSITIONING METHOD

(30) Priorité: 09.03.2007 FR 0701738
(43) Date de publication de la demande: 16.12.2009
(73) Titulaire: E2V Semiconductors, 38120 Saint Egrève (FR)
(72) Inventeur: SIMON, Gilles, F-38120 Le Fontanil (FR)
(74) Mandataire: Guérin, Michel
(86) Numéro de dépôt international: PCT/EP2008/052756
(87) Numéro de publication internationale: WO 2008/110511

(56) Documents cités:
- EP-A- 1 473 777
- JP-A- 1 217 950
- JP-A- 63 155 648
- US-A- 5 223 746
- US-B1- 6 683 298

## Description

L'invention concerne la fabrication des circuits intégrés en général, et notamment les circuits de capteurs d'image destinés à former le coeur électronique des caméras ou appareils photographiques.

Dans la suite on parlera uniquement de caméras, qu'il s'agisse d'appareils photographiques destinés à des prises de vue fixes ou d'appareils destinés à des prises de vues animées.

Un problème important qui se pose est le positionnement très précis du capteur d'image (une puce de circuit intégré) par rapport à l'optique de la caméra qui focalise une image sur ce capteur.

Les documents JP01217950, JP63155648 and US 5223746 montrent des examples de l'état de la technique de puces de capteur d'image placées dans des boîtiers en céramique.

Dans une situation idéale, il faut que le plan de la puce de circuit intégré soit parfaitement perpendiculaire à l'axe optique, et, en supposant cette condition réalisée, il faut d'une part que la surface active du capteur d'image soit dans le plan focal de la puce (alignement en Z), et d'autre part que les axes transversaux et longitudinaux de la puce (dans le plan de celle-ci) se croisent sur l'axe du système optique de la caméra (alignement en X et en Y).

La présente invention s'intéresse d'abord à l'alignement en X et en Y, mais aussi à l'alignement en Z. Le positionnement du capteur d'image par rapport à la caméra est fait en principe par des moyens mécaniques qui prennent le boîtier de la puce et le placent aussi précisément que possible par rapport à la caméra, aussi bien en X et Y (dans un plan "horizontal" qui est le plan de la surface de la puce) qu'en Z (dans une direction "verticale" perpendiculaire à la surface de la puce). La marge d'erreur liée aux moyens de positionnement mécanique du boîtier est d'une à deux centaines de micromètres. Elle dépend principalement des tolérances de dimensions du boîtier. Mais cette marge d'erreur suppose que la puce soit parfaitement positionnée (en général centrée) en X et Y dans son boîtier, et à une hauteur bien connue en Z par rapport à la surface inférieure du boîtier.

Pour centrer la puce dans le boîtier, et en même temps pour souder des fils de connexion entre la puce et le boîtier, les machines de mise en boîtier utilisent généralement un positionnement optique grâce à des marques d'indexation formées sur le boîtier. La machine saisit la puce, détecte la position des marques, et place la puce à un endroit centré par rapport aux marques. Ce positionnement optique est nécessaire en particulier pour faire en sorte que les fils de connexion entre la puce et le boîtier soient correctement mis en place et soudés sur les plots de connexion métalliques respectifs de la puce et du boîtier. Ces marques d'indexation sont utilisées en particulier sur les boîtiers en céramique, réalisés par superposition puis cuisson de couches multiples de céramique crue revêtues de dépôts métalliques sérigraphiés ; les marques d'indexation sont utilisées pour toutes sortes de circuits intégrés, c'est-à-dire pas seulement sur les capteurs d'image. Pour que le positionnement de la puce par rapport aux plots de connexion du boîtier soit optimisé, les marques d'indexation sont en général constituées par des zones métallisées faisant partie des mêmes couches de métallisation que les plots de connexion du boîtier ; les marques sont donc sérigraphiées en même temps que les plots de connexion et que d'autres conducteurs éventuels.

Mais si la position des marques est assez précise par rapport aux plots du boîtier puisqu'elles sont sérigraphiées en même temps, avec cependant une certaine imprécision résultant du mode de fabrication des boîtiers à partir de la cuisson de céramique crue, elle n'est pas très précise par rapport aux bords du boîtier car la sérigraphie n'est pas référencée par rapport aux bords du boîtier étant donné qu'elle est réalisée avant découpage des couches de céramique en boîtiers individuels. Ceci résulte des méthodes de fabrication de ces boîtiers ; typiquement, un boîtier de céramique est fait par superposition de feuilles de céramique crue sérigraphiées avec des pâtes conductrices ; la pile superposée est ensuite découpée en boîtiers individuels qui sont cuits à haute température. La position de la découpe de l'empilement par rapport aux marques d'indexation n'est pas suffisamment précise à cause de l'opération de cuisson qui réduit globalement les dimensions des couches dans une proportion d'environ 15%. La tolérance de position relative des motifs de découpe ou des motifs de sérigraphie des couches après cuisson n'est pas meilleure que 150 micromètres, voire même moins pour des grands boîtiers, et cette tolérance s'ajoute à l'erreur globale de positionnement de la puce lorsqu'on évalue la précision finale de positionnement de la puce par rapport à l'optique de la caméra.

Ce positionnement insuffisamment précis de la puce par rapport à l'optique de la caméra rend nécessaire un ajustement manuel coûteux, par exemple un réglage final de position par des vis micrométriques avant collage définitif du boîtier de la puce dans la caméra.

L'invention a pour but de proposer des moyens pour améliorer le positionnement relatif entre un capteur d'image monté sur un boîtier céramique multicouches et l'optique de la caméra.

L'invention concerne un boîtier de circuits intégrés et un procédé de positionnement tel que définis dans les revendications 1 et 9, respectivement.

Pour y parvenir, l'invention propose un boîtier de circuit intégré en céramique multicouches qui comporte plusieurs marques optiques d'indexation pour le positionnement d'une puce de circuit intégré dans le boîtier, les marques ayant un bord aligné avec un bord latéral extérieur du boîtier. De préférence, il y a au moins une marque sur un premier bord et deux marques sur un bord perpendiculaire au premier.

Les marques sont de préférence réalisées par des portions d'une couche conductrice servant également à former des plots d'interconnexion pour la soudure de fils de connexion sur ces plots.

De préférence, la hauteur des marques au-dessus d'un fond plat du boîtier est égale à la hauteur de la surface supérieure de la puce au-dessus du fond plat sur lequel elle est posée. On tient compte de préférence dans cette détermination de hauteur de l'épaisseur de colle ou de soudure pouvant exister entre la puce et le fond. Les marques sont ainsi placées dans un plan qui est le plus voisin possible du plan de la surface supérieure de la puce montée dans le boîtier.

Les marques sont de préférence placées sur une portion périphérique du boîtier, dans un plan situé au-dessous de la partie la plus haute du boîtier. Elles peuvent être formées soit sur un décrochement périphérique entourant tout le boîtier, soit dans des encoches locales (typiquement une encoche par marque) creusées dans la partie supérieure du boîtier. Si la marque est placée dans une encoche respective, elle peut occuper la totalité ou une partie seulement du fond de l'encoche.

Le procédé d'alignement selon l'invention, qui est un procédé de positionnement précis de puce de capteur d'image par rapport à un système optique d'une caméra, comprend deux étapes : ,
- alignement optique, par machine, de la puce dans un boîtier de circuit intégré comportant au moins une marque optique d'indexation ayant un bord aligné avec un bord latéral extérieur du boîtier ;
- et positionnement mécanique des bords extérieurs du boîtier par rapport à la caméra.

En pratique, le boîtier de céramique multicouche est fabriqué par superposition de plaques de couches de céramique crue sérigraphiées et découpées selon des motifs désirés, puis par subdivision de l'empilement de plaques de céramique crue en portions correspondant chacune à un boîtier individuel ; les motifs sérigraphiés comportent de préférence au moins un motif de marque d'indexation s'étendant à la fois sur deux portions adjacentes, la division en portions individuelles se faisant selon une ligne coupant ce motif en deux marques ayant chacune un bord aligné avec le bord découpé d'un boîtier respectif.

Les marques d'indexation peuvent servir de référence d'alignement soit mécanique soit optique en hauteur pour un positionnement précis du boîtier dans le sens de l'axe optique de la caméra.

D'autres caractéristiques et avantages de l'invention apparaîtront à la lecture de la description détaillée qui suit et qui est faite en référence aux dessins annexés dans lesquels :
- la figure 1 représente, en vue de dessus, un boîtier de circuit intégré classique en céramique multicouches, adapté ici à un capteur d'image en forme de barrette linéaire ;
- la figure 2 représente une vue en coupe agrandie montrant la disposition de la puce de capteur dans son boîtier ;
- la figure 3 représente un boîtier de circuit intégré modifié selon l'invention ;
- la figure 4 représente une vue en coupe agrandie du boîtier de la figure 3 avec sa puce ;
- la figure 5 représente une variante de réalisation du boîtier selon l'invention.

On considère à titre d'exemple un capteur d'image, en boîtier de céramique multicouches, l'invention étant tout particulièrement intéressante pour un capteur d'image bien que les marques d'indexation soient utiles pour n'importe quel autre type de circuit intégré. Le capteur d'image est, dans cet exemple, une barrette multilinéaire de forme très allongée.

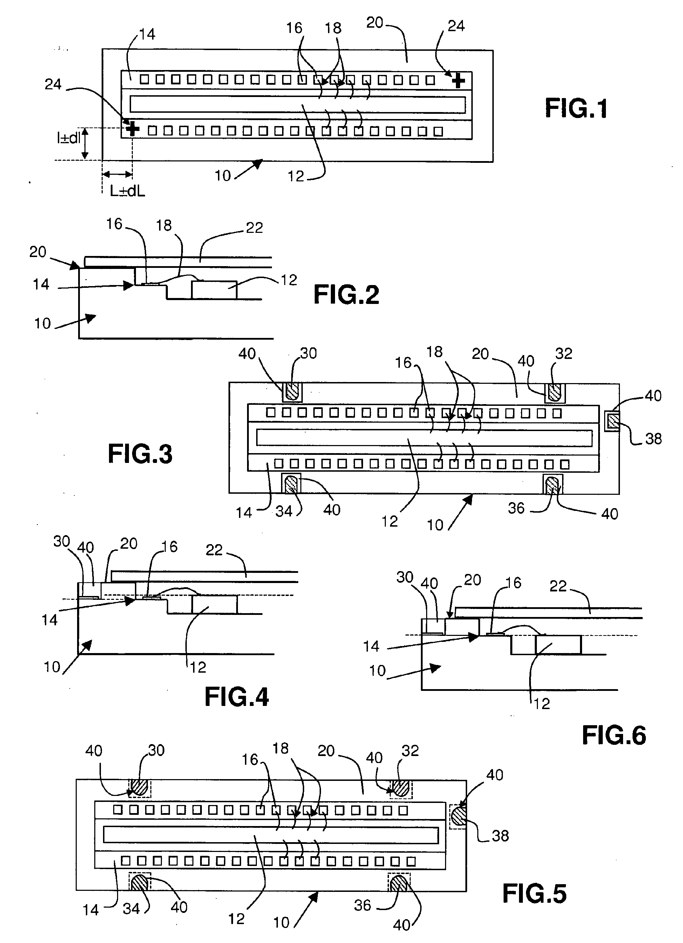

Le boîtier 10 de capteur d'image classique des figures 1 et 2 est rectangulaire et allongé ; il est par exemple en forme de double cuvette et possède un fond plat sur lequel repose la puce 12 de capteur d'image. Le boîtier comporte un premier rebord de cuvette, 14, qui entoure totalement ou partiellement la puce 12 ; le rebord est plan, parallèle au fond plat du boîtier. Sur la figure 1, le rebord 14 n'entoure que partiellement la puce puisqu'on ne trouve pas ce rebord sur les petits côtés du boîtier. La puce ne possède de plots de connexion électrique que sur ses grands côtés. Si elle en possédait sur ses quatre côtés (cas d'une puce carrée par exemple) le rebord 14 serait présent sur les quatre côtés.

Le rebord 14 porte des plots métallisés 16 servant à la soudure de fils de connexion 18 qui sont soudés entre chaque plot 16 et un plot correspondant, non représenté, formé sur la puce. Seuls quelques fils 18 sont représentés sur le dessin.

Le boîtier 10 comporte une deuxième rebord de cuvette 20, dans un plan parallèle au plan du premier rebord 14, plus haut que le premier, et plus haut que les fils 18.

Enfin, la puce et ses fils sont de préférence protégés par une plaque de protection transparente 22 (par exemple en verre) qui ferme la partie supérieure de la cuvette et qui s'étend parallèlement au fond plat du boîtier. Cette plaque est collée sur toute la périphérie du rebord 20. La plaque transparente 22 protège la puce, tout en laissant passer la lumière pour permettre au capteur d'image de recevoir une image à convertir en signaux électroniques.

Des marques d'indexation 24 (au moins deux) sont formées sur le rebord plan 14. Elles sont constituées par des portions isolées de la couche métallique qui sert à former les plots de connexion 16 du boîtier, et elles ont une forme permettant une aide pour un système de positionnement optique capable de les repérer. Le contraste entre la métallisation de la marque 24 et les parties non métallisées qui l'entoure permet ce repérage. Les marques peuvent être classiquement en forme de croix comme cela est représenté.

Ces marques sont utilisées au moment de la mise en place de la puce sur le fond plat du boîtier, et au moment de la soudure des fils de connexion entre la puce et le boîtier ; elles servent à l'appareil de manipulation et de soudure de la puce, assisté par le système de positionnement optique, pour placer la puce exactement à l'endroit désiré, de manière à pouvoir ensuite souder automatiquement et très précisément chaque fil de connexion 18 entre un plot de la puce et un plot respectif 16 du boîtier.

Les marques 24 sont placées d'une manière très précise par rapport aux plots 16 du boîtier. Elles sont d'ailleurs formées dans le même plan et à l'aide du même masque et de la même opération de gravure ou plus généralement de sérigraphie. Ainsi, on est à peu près sûr d'avoir une très faible marge d'erreur de positionnement entre ces marques et les plots.

Mais ces marques ne sont pas très précisément positionnées par rapport aux bords du boîtier. Elles sont par exemple à une distance l d'un grand bord dans la direction de la largeur du boîtier et une distance L d'un petit bord selon la longueur du boîtier, comme cela est représenté sur la figure 1. L'incertitude sur les valeurs de l et de L est importante car seule est considérée comme importante la position de la marque par rapport aux plots et parce que les opérations de cuisson à haute température de la céramique engendrent un rétrécissement de dimensions important (environ 15%) mais peu précis.

L'invention propose de modifier la constitution de la marque d'indexation pour que la marque possède un bord aligné avec un bord du boîtier. L'incertitude sur le positionnement de cette marque par rapport à ce bord devient nulle. S'il y a au moins une marque sur deux côtés perpendiculaires, on dispose alors d'au moins une marque dont l'incertitude de positionnement par rapport à un bord est nulle et une autre marque dont l'incertitude par rapport à un bord perpendiculaire est nulle.

Si les marques sont sérigraphiées ou gravées par le même masque que les plots métallisés, l'incertitude de positionnement de la marque par rapport à ces plots reste la même que dans le cas de la figure 1, c'est-à-dire faible. Au total la puce sera maintenant positionnée correctement non seulement par rapport aux plots mais aussi très précisément par rapport aux bords du boîtier.

La figure 3 et la figure 4 représentent le boîtier selon l'invention. Les mêmes références qu'aux figures 1 et 2 sont utilisées pour les mêmes éléments. Cinq marques ont été représentées à titre d'exemple: deux marques 30 et 32 sur un grand côté, deux marques 34 et 36 sur l'autre grand côté, et une marque 38 sur un petit côté perpendiculaire aux grands côtés. Un groupe de trois marques seulement pourrait suffire (deux sur un grand côté, une sur un petit côté), voire même deux seulement (un sur chacun de deux côtés perpendiculaires).

Chaque marque possède un bord rigoureusement aligné avec le côté respectif sur lequel elle est placée. Ce résultat est facile à obtenir compte-tenu du procédé de fabrication usuel des boîtiers de céramique : découpage par emboutissage de plaques de céramique crue d'assez grande dimension pour former simultanément plusieurs boîtiers juxtaposés les uns aux autres ; sérigraphie de métallisations sur ces plaques, pour la pluralité de boîtiers ; empilement des couches ; découpage des plaques empilées en boîtiers individuels ; et cuisson de la céramique. Lors de la sérigraphie, les marques d'indexation pourront être formées comme une marque deux fois plus longue servant pour deux boîtiers à la fois, mais ceci n'est pas obligatoire ; lors de la découpe selon une ligne séparant deux boîtiers juxtaposés, la marque est coupée en deux et chaque boîtier dispose d'une marque dont le bord découpé est exactement aligné avec le bord du boîtier.

Sur les figures 3 et 4, on a représenté les marques comme étant disposées chacune dans une encoche 40 creusée dans le rebord supérieur 20. La profondeur de l'encoche est de préférence égale à la différence de hauteur entre le rebord 20 (qui constitue la surface supérieure du boîtier) et le rebord 14, afin que les marques puissent être sérigraphiées en même temps que les plots métallisés sur une seule surface de céramique crue qui est la surface du rebord 14. Les encoches sont formées lors de l'opération de découpage/emboutissage des plaques de céramique crue (avant empilement de ces plaques).

Les marques vont servir au système de positionnement optique pour placer la puce et souder les fils de connexion entre la puce et les plots 16. Puis, lors du positionnement du boîtier (contenant la puce) à l'intérieur d'une caméra, ou à l'intérieur d'un système optique de caméra, le positionnement sera mécanique par rapport aux bords du boîtier, aussi bien dans le plan horizontal (en X et Y) que selon l'axe optique (en Z, perpendiculairement au fond du boîtier.

De préférence, la hauteur du fond de l'encoche au-dessus du fond plat du boîtier est égale à la hauteur de la surface supérieure de la puce au-dessus de ce fond plat (en tenant compte éventuellement d'une épaisseur de colle entre la puce et le fond du boîtier). Ainsi, la marque optique est dans le plan de la surface supérieure de la puce, qui est le plan sur lequel l'optique de focalisation de la caméra devra focaliser une image. Les marques peuvent alors encore mieux servir en outre au positionnement précis (optique ou mécanique) du boîtier dans la caméra dans une direction Z perpendiculaire au fond du boîtier, c'est-à-dire dans la direction de l'axe optique de la caméra.

On fera en sorte que la plaque de verre ne recouvre pas les encoches et les marques (ou tout au moins la partie véritablement utile des encoches et des marques). On facilite ainsi le positionnement vertical, dans le sens de la hauteur Z, du boîtier par rapport à la caméra.

Sur la figure 3, on a représenté des marques qui n'occupent pas tout le fond des encoches. On peut aussi, comme cela est représenté sur la figure 5, utiliser des encoches qui sont plus petites que les marques sérigraphiées, de sorte que la marque occupe tout le fond de l'encoche et c'est l'encoche elle-même qui définit les bords de la marque (bords autres que le bord aligné avec le bord de boîtier). Les traits pointillés de la figure 5 indiquent la surface de marque métallisée qui s'étend non seulement dans l'encoche mais tout autour des bords de l'encoche.

Inversement, les marques pourraient aussi ne pas être formées dans des encoches et être tout simplement sérigraphiées sur un rebord plan continu, en décrochement par rapport à la surface supérieure 20 du boîtier, ce rebord s'étendant tout autour de la périphérie extérieure du boîtier. La hauteur de ce rebord extérieur serait alors la même que la hauteur du rebord intérieur 14.

Sur la figure 4, on a représenté des marques d'indexation qui sont dans le plan des plots de connexion 16 mais qui ne sont pas nécessairement dans le plan du haut de la puce.

Sur la figure 6, on a choisi de placer les marques dans un plan qui est celui des plots de connexion 16 mais qui est aussi le plan de la surface supérieure de la puce 12. Le plan de la surface supérieure est le plan sur lequel le système optique de la caméra devra focaliser les images.

## Revendications

1. Boîtier de circuit intégré en céramique multicouches comportant plusieurs marques optiques d'indexation (30,32,34,36,38) pour le positionnement d'une puce de capteur d'image (12) dans le boîtier, **caractérisé en ce que** les marques ont un bord aligné avec un bord latéral extérieur du boîtier.

2. Boîtier de circuit intégré selon la revendication 1, **caractérisé en ce qu'**il comporte au moins une marque sur un premier bord (38) et deux marques (30, 32) sur un bord perpendiculaire au premier.

3. Boîtier de circuit intégré selon l'une des revendications 1 et 2, **caractérisé en ce que** les marques sont constituées par des portions d'une couche conductrice servant également à former des plots d'interconnexion (16) pour la soudure de fils de connexion (18) sur ces plots.

4. Boîtier selon l'une des revendications 1 à 3, **caractérisé en ce que** les marques sont formées à l'intérieur d'encoches (40) formées sur une surface supérieure du boîtier.

5. Boîtier selon la revendication 4, **caractérisé en ce que** la marque occupe tout le fond de l'encoche.

6. Boîtier selon l'une des revendications 1 à 3, **caractérisé en ce que** les marques sont formées sur un rebord périphérique (20) entourant toute la périphérie du boîtier et situé au-dessous de la surface supérieure du boîtier.

7. Boîtier selon l'une des revendications 1 à 6, contenant une puce de circuit intégré soudée et reliée électriquement au boîtier, **caractérisé en ce que** la puce est un capteur d'image pour une caméra.

8. Boîtier de circuit intégré selon la revendication 7, **caractérisé en ce que** la hauteur des marques au-dessus d'un fond plat du boîtier est égale à la hauteur de la surface supérieure de la puce au-dessus du fond plat sur lequel elle est posée.

9. Procédé de positionnement précis d'une puce de capteur d'image (12) par rapport à un système optique d'une caméra, comprenant une étape d'alignement optique, par machine, de la puce dans un boîtier (10) de circuit intégré en céramique multicouches comportant au moins une marque optique d'indexation (30, 32, 34, 36, 38), et une étape de positionnement mécanique des bords du boîtier par rapport à la caméra, **caractérisé en ce que** la marque a un bord aligné avec un bord latéral extérieur du boîtier.

10. Procédé selon la revendication 9, dans lequel le boîtier en céramique multicouches est fabriqué par superposition de plaques de céramique crue sérigraphiées et découpées selon des motifs désirés, puis par subdivision de la superposition de plaques de céramique crue en portions correspondant chacune à un boîtier individuel, **caractérisé en ce que** les motifs sérigraphiés comportent au moins un motif de marque d'indexation s'étendant à la fois sur deux portions adjacentes, la division en portions individuelles se faisant selon une ligne coupant ce motif en deux marques ayant chacune un bord aligné avec le bord découpé d'un boîtier respectif.

## Patentansprüche

1. Gehäuse für eine integrierte Schaltung aus mehreren Keramikschichten, die mehrere optische Indexierungsmarkierungen (30, 32, 34, 36, 38) zum Positionieren eines Bildsensorchips (12) in dem Gehäuse umfasst, **dadurch gekennzeichnet, dass** die Markierungen einen mit einem äußeren Seitenrand des Gehäuses ausgerichteten Rand haben.

2. Integriertes Schaltungsgehäuse nach Anspruch 1, **dadurch gekennzeichnet, dass** es wenigstens eine Markierung an einem ersten Rand (38) und zwei Markierungen (30, 32) an einem Rand lotrecht zu dem ersten aufweist.

3. Integriertes Schaltungsgehäuse nach einem der Ansprüche 1 und 2, **dadurch gekennzeichnet, dass** die Markierungen von Abschnitten einer leitenden Schicht gebildet werden, die auch zum Bilden von Verbindungskontakten (16) zum Löten von Verbindungsdrähten (18) an diese Kontakte dient.

4. Gehäuse nach einem der Ansprüche 1 bis 3, **dadurch gekennzeichnet, dass** die Markierungen im Innern von Kerben (40) ausgebildet sind, die auf einer Oberfläche des Gehäuses ausgebildet sind.

5. Gehäuse nach Anspruch 4, **dadurch gekennzeichnet, dass** die Markierung den gesamten Boden der Kerbe einnimmt.

6. Gehäuse nach einem der Ansprüche 1 bis 3, **dadurch gekennzeichnet, dass** die Markierungen an einer Umfangskante (20) ausgebildet sind, die den gesamten Umfang des Gehäuses umgibt und sich unterhalb der Oberfläche des Gehäuses befindet.

7. Gehäuse nach einem der Ansprüche 1 bis 6, das einen integrierten Schaltungschip enthält, der gelötet und elektrisch mit dem Gehäuse verbunden ist, **dadurch gekennzeichnet, dass** der Chip ein Bildsensor für eine Kamera ist.

8. Integriertes Schaltungsgehäuse nach Anspruch 7, **dadurch gekennzeichnet, dass** die Höhe der Markierungen über einem flachen Boden des Gehäuses gleich der Höhe der Oberfläche des Chips über dem flachen Boden ist, auf dem er angeordnet ist.

9. Verfahren zum präzisen Positionieren eines Bildsensorchips (12) in Bezug auf ein optisches System einer Kamera, das einen Schritt des optischen Ausrichtens, maschinell, des Chips in einem Gehäuse (10) für eine integrierte Schaltung aus mehreren Keramikschichten, die wenigstens eine optische Indexierungsmarkierung (30, 32, 34, 36, 38) umfasst, und einen Schritt des mechanischen Positionierens der Ränder des Gehäuses in Bezug auf die Kamera beinhaltet, **dadurch gekennzeichnet, dass** die Markierung einen mit dem äußeren Seitenrand des Gehäuses ausgerichteten Rand hat.

10. Verfahren nach Anspruch 9, bei dem das Gehäuse aus mehreren Keramikschichten wie folgt gefertigt wird: Aufeinanderlegen von rohen Keramikplatten, die gemäß gewünschten Motiven siebgedruckt und geschnitten werden, dann Unterteilen der aufeinander gelegten rohen Keramikplatten in Abschnitte, die jeweils einem individuellen Gehäuse entsprechen, **dadurch gekennzeichnet, dass** die siebgedruckten Motive wenigstens ein Indexierungsmarkierungsmotiv umfassen, das gleichzeitig über zwei benachbarte Abschnitte verläuft, wobei die Unterteilung in individuelle Abschnitte gemäß einer Linie erfolgt, die dieses Motiv in zwei Markierungen schneidet, die jeweils einen Rand aufweisen, der mit dem ausgeschnittenen Rand eines jeweiligen Gehäuses ausgerichtet ist.

## Claims

1. A multilayer ceramic integrated circuit package comprising several optical indexing marks (30, 32, 34, 36, 38) for positioning an image sensor chip in the package, **characterized in that** the marks have an edge aligned with an exterior lateral edge of the package.

2. The integrated circuit package as claimed in claim 1, **characterized in that** it comprises at least one mark on a first edge (38) and two marks (30, 32) on an edge perpendicular to the first.

3. The integrated circuit package as claimed in one of claims 1 and 2, **characterized in that** the marks consist of portions of a conducting layer also serving to form interconnection pads (16) for soldering connection wires (18) to these pads.

4. The package as claimed in one of claims 1 to 3, **characterized in that** the marks are formed inside notches formed on an upper surface of the package.

5. The package as claimed in claim 4, **characterized in that** the mark occupies the whole of the base of the notch.

6. The package as claimed in one of claims 1 to 3, **characterized in that** the marks are formed on a peripheral edge (20) surrounding the whole of the periphery of the package and situated below the upper surface of the package.

7. The package as claimed in one of claims 1 to 6, containing an integrated circuit chip soldered and linked electrically to the package, **characterized in that** the chip is an image sensor for a camera.

8. The integrated circuit package as claimed in claim 7, **characterized in that** the height of the marks above a flat base of the package is equal to the height of the upper surface of the chip above the flat base on which it is placed.

9. A method of accurate positioning of an image sensor chip (12) with respect to an optical system of a camera, comprising a step of optical alignment, by machine, of the chip in a multilayer ceramic integrated circuit package comprising at least one optical indexing mark (30, 32, 34, 36, 38), and a step of mechanical positioning of the edges of the package with respect to the camera, **characterized in that** the mark has an edge aligned with an exterior lateral edge of the package.

10. The method as claimed in claim 9, in which the multilayer ceramic package is fabricated by superposing plates of green ceramic silkscreen-printed and cut according to desired patterns, and then subdividing the superposition of plates of green ceramic into portions each corresponding to an individual package, **characterized in that** the silk-screen-printed patterns comprise at least one indexing mark pattern extending at one and the same time over two adjacent portions, the division into individual portions being done along a line slicing this pattern into two marks each having an edge aligned with the cut edge of a respective package.
